# EUROPEAN PATENT SPECIFICATION

(11) **EP 2 108 714 B1**
(45) Date of publication and mention of the grant of the patent: **12.03.2014**
(21) Application number: 07707612.3
(22) Date of filing: 29.01.2007
(51) Int. Cl.: C23C 16/511, C30B 29/04, H01L 21/205, H01J 37/32

(54) **MICROWAVE PLASMA CVD SYSTEM**
MIKROWELLEN-PLASMA-CVD-SYSTEM
SYSTÈME DE DÉPÔT CHIMIQUE EN PHASE VAPEUR (CVD) PAR PLASMA MICRO-ONDES

(43) Date of publication of application: 14.10.2009
(73) Proprietor: Sumitomo Electric Industries, Ltd., Chuo-ku Osaka-shi Osaka 540-0041 (JP)
(72) Inventor: UEDA, Akihiko, Itami-shi Hyogo 664-0016 (JP); MEGURO, Kiichi, Itami-shi Hyogo 664-0016 (JP); YAMAMOTO, Yoshiyuki, Itami-shi Hyogo 664-0016 (JP); NISHIBAYASHI, Yoshiki, Itami-shi Hyogo 664-0016 (JP); IMAI, Takahiro, Itami-shi Hyogo 664-0016 (JP)
(74) Representative: Boult Wade Tennant
(86) International application number: PCT/JP2007/051381
(87) International publication number: WO 2008/093389

(56) References cited:
- EP-A1- 1 376 670
- WO-A2-2006/017136
- JP-A- 05 182 785
- JP-A- 07 296 991
- JP-A- 2002 093 788
- JP-A- 2002 299 240
- JP-A- 2004 346 385
- US-B1- 6 427 621

## Description

### TECHNICAL FIELD

The present invention relates to a microwave plasma CVD device for forming carbon thin films such as diamond thin films, diamond-like carbon thin films and carbon nanotubes, and silicon thin films such as silicon oxide thin films, silicon nitride thin films and amorphous silicon thin films, and particularly diamond thin films.

### BACKGROUND ART

Chemical vapor deposition (CVD) is widely used in the formation of carbon thin films and particularly diamond thin films. Methane and hydrogen, for example, as used as raw materials, a radical that is a diamond precursor is formed by raw material gas activating means such as microwaves, heat filaments, high frequencies or direct-current discharge, and a diamond is deposited on a base material.

Because diamonds have the highest hardness among materials existing in nature, they are utilized in cutting tools and the like, but they also have extremely excellent physical properties as semiconductor materials. Their band gap is about 5.5 eV, which is extremely large, and their carrier mobility is 2000 cm²/Vs at room temperature for both electrons and holes, which is high. Further, their permittivity is 5.7, which is small, and their breakdown electric field is 5×10⁶V/cm, which is large. Moreover, they have the rare characteristic of negative electron affinity where a vacuum level is present at or below the lower end of the conduction band. For this reason, practical application of semiconductor devices that actively utilize the excellent semiconductor physics of diamonds is expected, such as environmentally-resistant devices that operate even under high-temperature environments and under space environments, power devices that are operable at high frequencies and high outputs, light-emitting devices that are capable of ultraviolet light emission, or electron-emitting devices that are capable of being driven at low voltages.

It is demanded that diamond thin films for semiconductor device fabrication be high-quality. As devices that synthesize high-quality diamond thin films, there are used microwave plasma CVD devices that can generate, by nonpolar discharge in which there is no incorporation of electrode material, high-density plasma that can fabricate a diamond whose crystallinity is good.

As microwave plasma CVD devices widely used in the synthesis of diamond thin films, there are: (1) a device that generates plasma by making incident TE mode microwaves by a rectangular waveguide from the side of quartz tube chamber such as in non-patent document 1; (2) a device that generates plasma by introducing TM mode microwaves by a cylindrical waveguide from directly above a metal chamber as in patent document 1; and (3) a device that generates plasma by introducing TEM mode microwaves by a coaxial waveguide to a metal chamber as in patent document 2.

However, each of these devices has problems that need to be solved in order to synthesize large-area high-quality diamond thin films (and specifically diamond thin films having an even film thickness and an even impurity concentration across a large area) necessary for semiconductor device fabrication. In order to synthesize large-area high-quality diamond thin films, it is necessary for the size of the plasma generated by the microwave plasma CVD device to be large, but in the case of the synthesis device of aforementioned (1), the size of the plasma is limited by the microwave waveguide and quartz tube size. For example, when 2.45 GHz microwaves are used, the size of the plasma is about 2.5 cm (1 inch ø), which is small, and the region where even film thickness and impurity concentration are obtained is even smaller. Further, when the plasma size is increased, the plasma contacts the quartz tube, so there is the potential for the quartz tube to be directly heated by the plasma and break. In order to obtain a large-area high-quality diamond thin film, the synthesis rate is about 1 to 2 µm/h, and prolonged continuous running when a thin film of about 10 µm is needed is difficult.

In the case of the synthesis device of aforementioned (2) also, prolonged continuous running when increasing the plasma size and performing synthesis is difficult. In the case of the synthesis device of aforementioned (3), the aforementioned problems do not exist because the plasma cannot be seen from a microwave introduction window. However, because it is difficult to adjust the distance between the electrode and the top plate while generating the plasma, it is difficult to adjust the plasma shape which differs depending on the size of the base material, gas introduction conditions, pressure conditions, and microwave power conditions, and a tremendous amount of time and labor are required in order to obtain the intended high-quality diamond thin film.

In order to solve the problem of aforementioned (3), a device has been proposed which enables substrate supporting means such as in patent document 3 to be raised and lowered in a non-stepped manner with respect to plasma generating means to adjust the shape of the plasma in a non-stepped manner. However, when the substrate supporting means and the plasma generating means take the parallel plate structure described in patent document 3, a region whose electric field strength is strong in a steady state inside the vacuum chamber into which microwaves have been introduced interconnects these, so the plasma ends up contacting both the substrate supporting means and the plasma generating means. Or, the region whose electric field strength is strong divides between both the substrate supporting means and the plasma generating means, so the plasma also ends up generating dividedly between both.

Further, a microwave plasma generation method has been disclosed in Japanese Patent publication JP 2004-346385 A capable of generating a plasma of high density in a wider region by providing an electrode on the vacuum side of a dielectric window.

European Patent Application EP 1376670 A1 discloses a microwave plasma processing apparatus with a transmission window having a concaved surface at a side facing the substrate in order to generate an uniform plasma.

These plasma distribution tendencies are remarkable at 10 to 200 Torr which is a pressure region of the vacuum chamber in which high-quality diamond thin films are formed. The tendency for the plasma to be localized is largely different from the distribution tendency when plasma is generated by a high frequency in a pressure region where the energy necessary to cause gas of several Torr or less used in semiconductor processes, such as dry etching devices and the like, for example, to be ionized is relatively small. And, because it is plasma of a relatively high pressure region, the gas temperature is also high, and when the plasma contacts a portion other than the substrate, a large energy loss occurs and makes the plasma size smaller. That is, it has been difficult to say that plasma position control under conditions capable of fabricating large-area high-quality diamond thin films can be satisfactorily performed.
Non-patent document 1: M. Kamo, et al, : J. Cryst. Growth, 62, p. 642 (1983)
Patent document 1: US 5,153,406
Patent document 2: US 5,556,475
Patent document 3: JP No. 2000-54142 A

### DISCLOSURE OF THE INVENTION

### PROBLEM THAT THE INVENTION IS TO SOLVE

Thus, it is an object of the present invention to provide a microwave plasma CVD device that enables plasma position control under conditions where there is no contact between the plasma and dielectric material even when the size of plasma resulting from microwaves introduced in TE, TM and TEM modes is increased, that is, conditions that are capable of prolonged synthesis of large-area high-quality diamond thin films or the like and are capable of fabricating high-quality diamond thin films or the like.

### MEANS FOR SOLVING THE PROBLEM

In order to solve this problem, the present inventor has discovered, as a result of thorough examination, that the aforementioned object is achieved by giving an electrode portion on the distal end of an antenna portion in a microwave plasma CVD device a size equal to or greater than that of a dielectric window and forming a concave portion of a predetermined size in the surface of the electrode portion that faces the center of a vacuum chamber.

That is, a microwave plasma CVD device according to the present invention comprises at least: a vacuum chamber having an open portion for introducing microwaves; a waveguide for guiding the microwaves to the open portion; a dielectric window for introducing the microwaves to the inside of the vacuum chamber; an antenna portion where an electrode portion is formed on a distal end for introducing the microwaves to the inside of the vacuum chamber; and a base material support table for supporting a base material inside the vacuum chamber, with the dielectric window being held between an inner surface of the vacuum chamber and the electrode portion, wherein an end surface of the electrode portion is formed equal to or wider than an end surface of the dielectric window such that the dielectric window is hidden, a concave portion is formed in a surface of the electrode portion that faces the center of the vacuum chamber, and the diameter of the concave portion at the surface that faces the center of the vacuum chamber is in the range of 1/3 to 5/3 the wavelength of the microwaves to be introduced and the depth of the concave portion from the surface that faces the center of the vacuum chamber to the deepest portion of the concave portion is in the range of 1/20 to 3/5 the wavelength of the microwaves to be introduced.

Further, the surface of the concave portion in the microwave plasma CVD device according to the present invention may be spheroidal. Or, the surface of the concave portion in the microwave plasma CVD device according to the present invention may be spherical.

### EFFECTS OF THE INVENTION

According to the microwave plasma CVD device according to the present invention, the microwave plasma CVD device is capable of prolonged synthesis of diamonds or the like and is capable of appropriately creating large-area high-quality semiconductor diamonds or the like because it can simply stably generate plasma whose size is large directly above the base material even when synthesis conditions such as synthesis pressure and incident microwave power are changed.

### BRIEF DESCRIPTION OF THE DRAWINGS

[FIG. 1] A cross-sectional diagram showing an embodiment of a microwave plasma CVD device pertaining to the present invention.
[FIG. 2] A cross-sectional diagram showing another embodiment.
[FIG. 3] A cross-sectional diagram showing yet another embodiment.

### DESCRIPTION OF THE REFERENCE NUMERALS

- 1: Vacuum Chamber
- 2: Circular Open Portion
- 3: Vacuum Chamber Interior
- 4: Window
- 5: Port
- 10: Foundation Base Material
- 11: Base Material Support Table
- 20: Microwaves
- 21: (Cylindrical) Waveguide
- 22: Dielectric Window
- 23: Round Rod Portion
- 24, 34, 44: Electrode Portions
- 25: Antenna Portion
- 26, 27, 28: Concave Portions
- 40: Raw Material Gas Supply Tube
- 41: Exhaust Gas Tube
- 42: Plasma

### BEST MODE FOR CARRYING OUT THE INVENTION

Below, examples of preferred embodiments of a microwave plasma CVD device pertaining to the present invention will be described in detail with reference to the drawings. In the description of the drawings, the same reference numerals will be given to the same elements and redundant description will be omitted. Further, the dimensional ratios in the drawings do not invariably match those in the description.

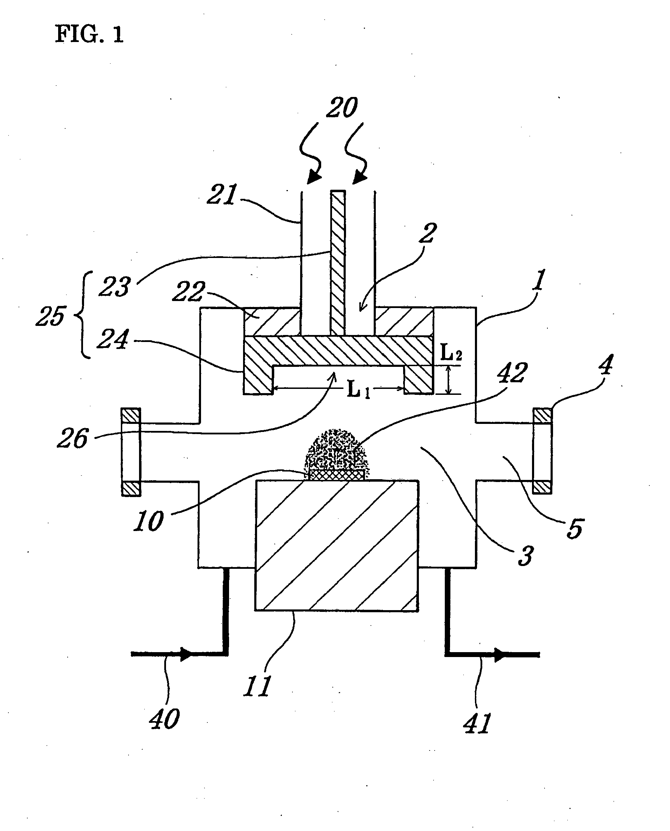

FIG. 1 is a cross-sectional diagram showing an embodiment of a microwave plasma CVD device according to the present invention. A vacuum chamber 1 is made of metal and is preferably made of stainless steel, molybdenum, or aluminum. The vacuum chamber 1 has a circular open portion 2 in the center of its upper portion and also has a window 4 for observing a vacuum chamber interior 3 in its side. A port 5 of the window 4 is designed to have a diameter and length such that microwaves do not leak from the window 4. A material that is transparent with respect to visible light, such as quartz or kovar, is preferable for the window 4. A base material support table 11 for holding a foundation base material 10 for growing diamonds is disposed in the lower portion of the vacuum chamber 1. The base material support table 11 is, similar to the vacuum chamber, made of metal, its vertical position is capable of being adjusted, a cooling water tube and a heater are incorporated inside, and it can adjust the temperature of the foundation base material 10.

A cylindrical waveguide 21 for guiding microwaves 20 to the circular open portion 2 is disposed directly above the circular open portion 2. As for the microwaves 20, a 2.45 GHz band or 915 MHz band wavelength is appropriately usable, but the microwaves 20 are not limited to the above mentioned bands as long as they have a wavelength capable of generating plasma. As for the (cylinder) waveguide 21, a metal such as stainless steel, molybdenum, or aluminum is appropriately usable, but it is preferable for the inner surface to be plated with a metal whose resistivity is small, such as silver, gold, or copper, in order to reduce transmission loss of the microwaves 20. A ring-shaped dielectric window 22 for introducing the microwaves 20 to the vacuum chamber interior 3 is disposed around the circular open portion 2. As for the material of the ring-shaped dielectric window 22, alumina or the like is appropriately usable.

A round rod portion 23 is positioned in the center of the waveguide 21, the circular open portion 2 and the dielectric window 22, and the round rod portion 23 is connected to a disc-shaped electrode portion 24 that holds the ring-shaped dielectric window 22 between itself and the inside portion of the upper surface of the vacuum chamber 1 for vacuum-holding the microwave introduction portion. The round rod portion 23 and the electrode portion 24 form an antenna portion 25 for introducing the microwaves 20 to the vacuum chamber 1. As for the material of the antenna portion 25, the same metal as that of the waveguide 21 is appropriately usable, and the antenna portion 25 configures a coaxial waveguide together with the waveguide 21 to introduce TEM mode microwaves to the vacuum chamber interior 3. The microwaves 20 are typically transmitted by a microwave oscillator and a microwave component comprising an isolator, a power monitor, a matching box and a rectangular-coaxial converter to the coaxial waveguide configured by the (cylinder) waveguide 21 and the round rod portion 23. Raw material gas is supplied by a raw material gas supply tube 40 to the vacuum chamber interior 3.

When a diamond is to be vapor-grown, a carbon source such as hydrogen, methane, propylene, or acetylene is used as the raw material gas, and when a semiconductor diamond is to be fabricated by doping, an impurity source such as phosphine or diborane is used. When a high-quality diamond is to be fabricated, the vacuum chamber 3 is held at a pressure of 10 to 200 Torr by adjusting a pressure regulating valve of an exhaust gas tube 41, and a diamond grows the foundation base material 10 that is temperature-controlled at 700 to 1200°C by the base material support table 11 by an active species within the plasma generated by the introduced microwaves.

The present inventor performed a thorough examination in regard to measures for enabling, in the microwave plasma CVD device, plasma position control where there is no contact between the plasma and dielectric material even when the plasma size is increased, that is, conditions that are capable of prolonged synthesis of large-area high-quality diamond thin films and are capable of fabricating high-quality diamond thin films. As a result, the present inventor discovered that the aforementioned object is achieved by giving the electrode portion 24 on the distal end of the antenna portion 25 a diameter equal to or greater than that of the ring-shaped dielectric window 2 and forming, in the lower portion of the electrode portion 24, one concave portion 26 where the diameter (L₁) of the surface that faces the center of the vacuum chamber is within the range of 1/3 to 5/3 the wavelength of the microwaves that are introduced and where the depth (L₂) from the surface that faces the center of the vacuum chamber to the deepest portion of the concave portion is within the range of 1/20 to 3/5 the wavelength of the microwaves that are introduced.

In the microwave plasma CVD device, by giving the electrode portion 24 on the distal end of the antenna portion 25 a diameter equal to or greater than that of the dielectric window 22, the dielectric window 22 cannot be directly seen from the plasma 42, so these do not contact each other. Further, although the microwaves pass through the vacuum chamber in the vicinity of the dielectric window 22, the electric field strength thereof is weak and does not lead to plasma being generated there. Further, a dielectric material such as quartz is used for the window 4, but because the diameter and length of the port 5 are selected such that the microwaves do not leak from the window 4, the electric field strength in the vicinity of the window 4 is substantially equal to zero and plasma is not generated there. Consequently, because the plasma does not contact the dielectric configuring the device even when the plasma size is increased, prolonged synthesis of large-area high-quality diamond thin films (and specifically diamond thin films having an even film thickness and an even impurity concentration across a large area) becomes possible. Moreover, there is little unintended mixing of impurities in the diamond thin films which occurs as a result of the dielectric material being sputtered by the plasma.

Further, by forming, in the lower portion of the electrode portion 24, the one concave portion 26 where the diameter (L₁) at the surface that faces the center of the vacuum chamber is within the range of 1/3 to 5/3 the wavelength of the microwaves that are introduced and where the depth (L₂) from the surface that faces the center of the vacuum chamber to the deepest portion of the concave portion is within the range of 1/20 to 3/5 the wavelength of the microwaves that are introduced, a portion having an electric field strength of an extent where plasma is generated is not distributed across the base material support table 11 and the electrode portion 24 even when the distance between the upper portion of the base material support table 11 and the lower portion of the electrode portion 24 is changed and is also not distributed dividedly between the vicinity of the upper portion of the base material support table 11 and the vicinity of the lower portion of the electrode portion 24.

The oscillation frequency of a magnetron that oscillates the microwaves is changed by running conditions such as output and operating time, but by using a magnetron whose fluctuation is within 2% with respect to a nominal frequency, that is, an ordinarily procurable magnetron, this is realized. That is, the portion having an electric field strength of an extent where plasma is generated becomes concentrated just in the vicinity of the upper portion of the base material support table 11, so plasma whose size is large is stably generated in the vicinity of the upper portion of the base material support table 11 even under conditions capable of fabricating large-area high-quality diamond thin films, and the problem of position control that conventional microwave plasma CVD devices have not longer occurs.

In the concave portion 26, it is preferable for the diameter (L₁) at the surface that faces the center of the vacuum chamber to be within the range of 1/2 to 3/2 the wavelength of the microwaves that are introduced and for the depth (L₂) from the surface that faces the center of the vacuum chamber to the deepest portion of the concave portion to be within the range of 1/10 to 1/2 the wavelength of the microwaves that are introduced. When the diameter and the depth are in these ranges, plasma whose size is large can be stably generated in the vicinity of the upper portion of the base material support table 11 even with respect to a relatively unstable magnetron that fluctuates within 5% with respect to a nominal frequency. When the diameter (L₁) at the surface that faces the center of the vacuum chamber is outside the range of 1/3 to 5/3 the wavelength of the microwaves that are introduced, or when the depth (L₂) from the surface that faces the center of the vacuum chamber to the deepest portion of the concave portion is outside the range of 1/20 to 3/5 the wavelength of the microwaves that are introduced, it becomes easier for the portion having an electric field strength of an extent where plasma is generated to be distributed across the area between the upper portion of the base material support table 11 and the lower portion of the electrode portion 24 or to be distributed dividedly between the vicinity of the upper portion of the base material support table 11 and the vicinity of the lower portion of the electrode portion 24.

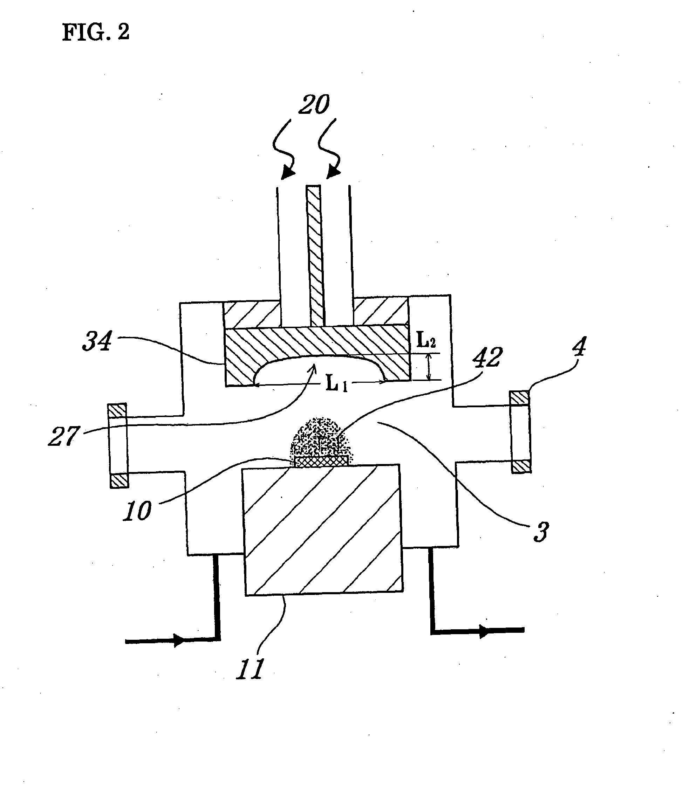

Moreover, as shown in FIG. 2, by configuring the surface of a concave portion formed in the undersurface of an electrode portion 34 as a spheroidal concave portion 27, the effect of causing the portion having an electric field strength of an extent where the plasma 42 is generated to be concentrated just in the vicinity of the upper portion of the base material support table 11 becomes more remarkable, plasma that is larger is generated in a device having the spheroidal concave portion 27 even under the same plasma generating conditions, and the area of film formation of high-quality diamonds expands.

Further, the diameter (L₁) at the surface of the concave portion 27 of the electrode portion 34 that faces the center of the vacuum chamber is in the range of 1/3 to 5/3 the wavelength of the microwaves that are introduced, and the depth (L₂) from the surface that faces the center of the vacuum chamber to the deepest portion of the concave portion is in the range of 1/20 to 3/5 the wavelength of the microwaves that are introduced.

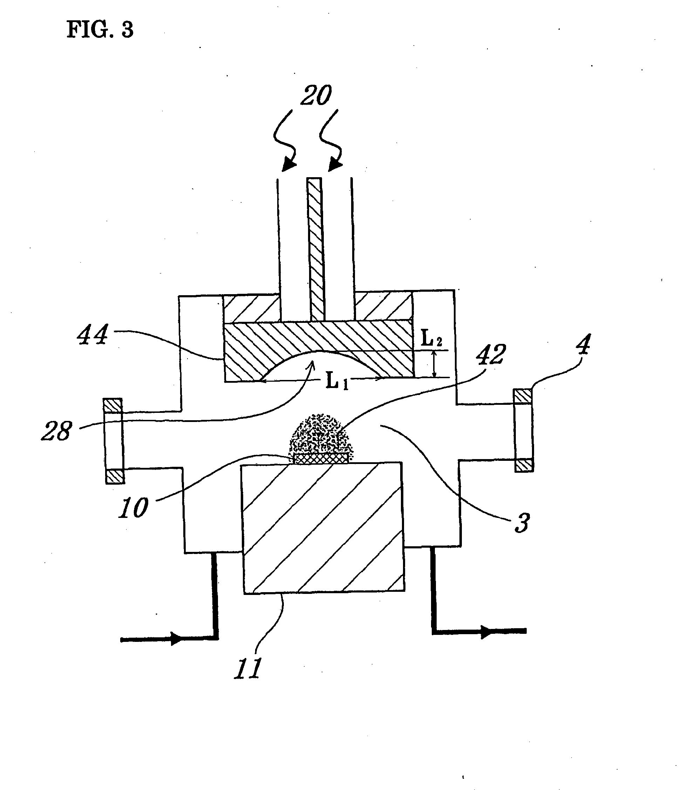

Alternatively, as shown in FIG. 3, by configuring the surface of a concave portion formed in the undersurface of an electrode portion 44 as a spherical concave portion 28, similar to the instance of configuring the surface of the concave portion formed in the undersurface of the electrode portion as the spheroidal concave portion 27, the effect of causing the portion having an electric field strength of an extent where the plasma 42 is generated to be concentrated just in the vicinity of the upper portion of the base material support table 11 becomes more remarkable, plasma that is larger is generated in a device having the spherical concave portion 28 even under the same plasma generating conditions, and the area of film formation high-quality diamonds expands.

Further, the diameter (L₁) at the surface of the concave portion 28 of the electrode portion 44 that faces the center of the vacuum chamber is in the range of 1/3 to 5/3 the wavelength of the microwaves that are introduced, and the depth (L₂) from the surface that faces the center of the vacuum chamber to the deepest portion of the concave portion is in the range of 1/20 to 3/5 the wavelength of the microwaves that are introduced.

According to the above, the microwave plasma CVD device according to the present invention is capable of prolonged synthesis of large-area high-quality diamond thin films and is capable of appropriately creating large-area high-quality semiconductor diamonds or the like because it can simply stably generate plasma whose size is large directly above the base material even when synthesis conditions such as synthesis pressure and incident microwave power are changed.

### EXAMPLES

Below, examples of the present invention will be described with reference to the attached drawings.

### <Example 1>

The microwave plasma CVD device shown in FIG. 1 was fabricated and synthesis of a semiconductor diamond was attempted. The microwaves 20 were a 2.45 GHz band, and as for the size of the concave portion 26, with respect to 1 wavelength of 122 mm of 2.45 GHz microwaves, the diameter (L₁) at the surface facing the center of the vacuum chamber was made equal to the length of 1 wavelength and the depth (L₂) from the surface facing the center of the vacuum chamber to the deepest portion of the concave portion was made equal to 1/5 wavelength. As the material of the device configural parts, stainless steel was used for the metal part and quartz was used for the dielectric part. As the base material 10, one comprising a 2×2×0.3 mmt high-temperature high-pressure synthetic IIa (111) monocrystalline substrate disposed squarely on the center and outer peripheral portion of a 50 mmø × 2 mmt molybdenum disc was used. From the raw material gas supply tube 40, hydrogen, methane and phosphine whose flow rates were adjusted by a mass flow controller were introduced to the vacuum chamber interior 3. The gas flow rates were 1 slm for hydrogen, 0.5 sccm for methane, and 1 sccm for phosphine (hydrogen diluted 1,000 ppm). The pressure regulating valve of the exhaust gas tube 41 was adjusted and the pressure of the vacuum chamber interior 3 was held at 100 Torr. The power of the microwaves 20 was 3 kW to generate the plasma 42.

When the vertical position of the base material support table 11 was adjusted, all of the five disposed monocrystalline substrates were covered by the hemispherical plasma 42. The temperatures of the five base materials were held at 900±10°C by a radiation thermometer from the window 4, and diamond thin film synthesis was performed for 6 hours. The behavior of the plasma was observed during the synthesis time but was stable directly above the base materials. When the surfaces of the monocrystalline substrates after synthesis were checked, growth of a good-quality homoepitaxial thin film was confirmed in all five. When the film thicknesses were measured, all five were within 3±0.05µm. When Hall effect measurement was performed, it was confirmed that a high-quality n-type epitaxial thin film whose room temperature mobility was 600 to 700 cm²/Vs was grown in all five. When impurity measurement by SIMS was performed, the phosphorous concentration within the films was between 7×10¹⁸ cm⁻³ and 8×10¹⁸ cm⁻³ in all five.

In the above-described condition, without setting the base material 10, the pressure of the vacuum chamber interior 3 was adjusted between 10 to 200 Torr, the microwave power was adjusted between 0.5 to 5 kW, and the plasma 42 was generated, but by adjusting the vertical position of the base material support table 11, the hemispherical plasma 42 of about 50 mmø could be stably generated directly above the base material support table 11.

### <Example 2>

The same experiment as Example 1 was performed except that, in regard to the concave portion 26, a concave portion was used which was fabricated by selecting any 1 size of 1/3 wavelength, 1/2 wavelength, 1 wavelength, 3/2 wavelength and 5/3 wavelength for the diameter (L₁) at the surface facing the center of the vacuum chamber and selecting any 1 size of 1/20 wavelength, 1/10 wavelength, 1/3 wavelength, 1/2 wavelength and 3/5 wavelength for the depth (L₂) from the surface facing the center of the vacuum chamber to the deepest portion of the concave portion, and substantially the same results as Example 1 were obtained. Particularly in the experiment using a concave portion where the diameter (L₁) at the surface facing the center of the vacuum chamber was in the range of 1/2 to 3/2 wavelength and where the depth (L₂) from the surface facing the center of the vacuum chamber to the deepest portion of the concave portion was 1/10 to 1/2 wavelength, stable semiconductor diamond synthesis could be realized without any plasma flickering being observed.

### <Comparative Example 1>

The same experiment as Example 1 was attempted except that, in regard to the size of the concave portion 26, a concave portion was used which was fabricated by selecting 1/5 wavelength for the diameter (L₁) at the surface facing the center of the vacuum chamber and selecting 1/25 wavelength for the depth (L₂) from the surface facing the center of the vacuum chamber to the deepest portion of the concave portion, but semiconductor diamond synthesis failed.

### <Example 3>

The antenna portion 25 of the microwave plasma CVD device shown in FIG. 1 was replaced with the electrode portion 34 including the spheroidal concave portion 27 shown in FIG. 2. As for the size of the concave portion 27, the diameter (L₁) at the surface facing the center of the vacuum chamber was made equal to the length of 1 wavelength and the depth (L₂) from the surface facing the center of the vacuum chamber to the deepest portion of the concave portion was made equal to 1/5 wavelength, as the base material 10, one comprising a 2×2×0.3 mmt high-temperature high-pressure synthetic IIa (111) monocrystalline substrate disposed squarely on the center and outer peripheral portion of a 60 mmø × 2 mmt molybdenum disc was used, and the same experiment as Example 1 was conducted. The power of the microwaves 20 was 3 kW to generate the plasma 42, and when the vertical position of the base material support table 11 was adjusted, all of the five disposed monocrystalline substrates were covered by the hemispherical plasma 42. The temperatures of the five base materials were held at 900±10°C by a radiation thermometer from the window 4, and diamond thin film synthesis was performed for 6 hours. The behavior of the plasma was observed during the synthesis time but was stable directly above the base materials.

When the surfaces of the monocrystalline substrates after synthesis were checked, growth of a good-quality homoepitaxial thin film was confirmed in all five. When the film thicknesses were measured, all five were within 3±0.05µm. When Hall effect measurement was performed, it was confirmed that a high-quality n-type epitaxial thin film whose room temperature mobility was 600 to 700 cm²/Vs was grown in all five. When impurity measurement by SIMS was performed, the phosphorous concentration within the films was between 7×10¹⁸ cm⁻³ and 8×10¹⁸ cm⁻³ in all five.

In the above-described condition, without setting the base material 10, the pressure of the vacuum chamber interior 3 was adjusted between 10 to 200 Torr, the microwave power was adjusted between 0.5 to 5 kW, and the plasma 42 was generated, but by adjusting the vertical position of the base material support table 11, the hemispherical plasma 42 of about 60 mmø could be stably generated directly above the base material support table 11.

### <Example 4>

The same experiment as Example 3 was performed except that, in regard to the concave portion 27, a concave portion was used which was fabricated by selecting any 1 size of 1/3 wavelength, 1/2 wavelength, 1 wavelength, 3/2 wavelength and 5/3 wavelength for the diameter (L₁) at the surface facing the center of the vacuum chamber and selecting any 1 size of 1/20 wavelength, 1/10 wavelength, 1/3 wavelength, 1/2 wavelength and 3/5 wavelength for the depth (L₂) from the surface facing the center of the vacuum chamber to the deepest portion of the concave portion, and substantially the same results as Example 3 were obtained. Particularly in the experiment using a concave portion where the diameter (L₁) at the surface facing the center of the vacuum chamber was in the range of 1/2 to 3/2 wavelength and where the depth (L₂) from the surface facing the center of the vacuum chamber to the deepest portion of the concave portion was 1/10 to 1/2 wavelength, stable semiconductor diamond synthesis could be realized without any plasma flickering being observed.

### <Comparative Example 2>

The same experiment as Example 3 was attempted except that, in regard to the size of the concave portion 27, a concave portion was used which was fabricated by selecting 1/5 wavelength for the diameter (L₁) at the surface facing the center of the vacuum chamber and selecting 1/25 wavelength for the depth (L₂) from the surface facing the center of the vacuum chamber to the deepest portion of the concave portion, but the plasma distributed across the area between the upper portion of the base material support table 11 and the lower portion of the electrode portion 34 and semiconductor diamond synthesis failed.

### <Example 5>

The antenna portion 25 of the microwave plasma CVD device shown in FIG. 1 was replaced with the electrode portion 44 including the spherical concave portion 28 shown in FIG. 3. As for the size of the concave portion 28, the diameter (L₁) at the surface facing the center of the vacuum chamber was made equal to the length of 1 wavelength and the depth (L₂) from the surface facing the center of the vacuum chamber to the deepest portion of the concave portion was made equal to 1/5 wavelength, as the base material 10, one comprising a 2×2×0.3 mmt high-temperature high-pressure synthetic IIa (111) monocrystalline substrate disposed squarely on the center and outer peripheral portion of a 70 mmø × 2 mmt molybdenum disc was used, and the same experiment as Example 1 was conducted. The power of the microwaves 20 was 3 kW to generate the plasma 42, and when the vertical position of the base material support table 11 was adjusted, all of the five disposed monocrystalline substrates were covered by the hemispherical plasma 42. The temperatures of the five base materials were held at 900±10°C by a radiation thermometer from the window 4, and diamond thin film synthesis was performed for 6 hours. The behavior of the plasma was observed during the synthesis time but was stable directly above the base materials.

When the surfaces of the monocrystalline substrates after synthesis were checked, growth of a good-quality homoepitaxial thin film was confirmed in all five. When the film thicknesses were measured, all five were within 3±0.05µm. When Hall effect measurement was performed, it was confirmed that a high-quality n-type epitaxial thin film whose room temperature mobility was 600 to 700 cm²/Vs was grown in all five. When impurity measurement by SIMS was performed, the phosphorous concentration within the films was between 7×10¹⁸ cm⁻³ and 8×10¹⁸ cm⁻³ in all five. In the above-described condition, without setting the base material 10, the pressure of the vacuum chamber interior 3 was adjusted between 10 to 200 Torr, the microwave power was adjusted between 0.5 to 5 kW, and the plasma 42 was generated, but by adjusting the vertical position of the base material support table 11, the hemispherical plasma 42 of about 70 mmø could be stably generated directly above the base material support table 11.

### <Example 6>

The same experiment as Example 5 was performed except that, in regard to the concave portion 28, a concave portion was used which was fabricated by selecting any 1 size of 1/3 wavelength, 1/2 wavelength, 1 wavelength, 3/2 wavelength and 5/3 wavelength for the diameter (L₁) at the surface facing the center of the vacuum chamber and selecting any 1 size of 1/20 wavelength, 1/10 wavelength, 1/3 wavelength, 1/2 wavelength and 3/5 wavelength for the depth (L₂) from the surface facing the center of the vacuum chamber to the deepest portion of the concave portion, and substantially the same results as Example 5 were obtained. Particularly in the experiment using a concave portion where the diameter (L₁) at the surface facing the center of the vacuum chamber was in the range of 1/2 to 3/2 wavelength and where the depth (L₂) from the surface facing the center of the vacuum chamber to the deepest portion of the concave portion was 1/10 to 1/2 wavelength, stable semiconductor diamond synthesis could be realized without any plasma flickering being observed.

### <Comparative Example 3>

The same experiment as Example 5 was attempted except that, in regard to the size of the concave portion 28, a concave portion was used which was fabricated by selecting 1/5 wavelength for the diameter (L₁) at the surface facing the center of the vacuum chamber and selecting 1/25 wavelength for the depth (L₂) from the surface facing the center of the vacuum chamber to the deepest portion of the concave portion, but the plasma distributed across the area between the upper portion of the base material support table 11 and the lower portion of the electrode portion 34 and semiconductor diamond synthesis failed.

## Claims

1. A microwave plasma CVD device comprising at least:
a vacuum chamber (1) having an open portion (2) for introducing microwaves;
a waveguide (21) for guiding the microwaves to the open portion;
a dielectric window (22) for introducing the microwaves to the inside of the vacuum chamber (1);
an antenna portion (25) where an electrode portion (24) is formed on a distal end for introducing the microwaves to the inside of the vacuum chamber (1); and
a base material support table (11) for supporting a base material inside the vacuum chamber (1),
with the dielectric window (22) being held between an inner surface of the vacuum chamber (1) and the electrode portion (24),
an end surface of the electrode portion (24) being formed equal to or wider than an end surface of the dielectric window (22) such that the dielectric window (22) is hidden,
**characterized in that** a concave portion (26) is formed in a surface of the electrode portion (24) that faces the center of the vacuum chamber (1), and
the diameter of the concave portion (26) at the surface that faces the center of the vacuum chamber is in the range of 1/3 to 5/3 the wavelength of the microwaves that are introduced and the depth of the concave portion from the surface that faces the center of the vacuum chamber to the deepest portion of the concave portion is in the range of 1/20 to 3/5 the wavelength of the microwaves that are introduced.

2. The microwave plasma CVD device of claim 1, wherein the surface of the concave portion is spheroidal.

3. The microwave plasma CVD device of claim 1, wherein the surface of the concave portion is spherical.

## Patentansprüche

1. Mikrowellenplasma CVD-Vorrichtung, umfassend wenigstens:
eine Vakuumkammer (1), die einen offenen Abschnitt (2) zum Einleiten von Mikrowellen hat;
einen Wellenleiter (21) zum Leiten der Mikrowellen zu dem offenen Abschnitt;
ein dielektrisches Fenster (22) zum Einleiten der Mikrowellen in das Innere der Vakuumkammer (1);
einen Antennenabschnitt (25), bei dem ein Elektrodenabschnitt (24) an einem distalen Ende ausgebildet ist, um die Mikrowellen in das Innere der Vakuumkammer (1) einzuleiten; und
einen Basismaterial-Trägertisch (11) für die Aufnahme eines Basismaterials im Inneren der Vakuumkammer (1),
wobei das dielektrische Fenster (22) zwischen einer Innenfläche der Vakuumkammer (1) und dem Elektrodenabschnitt (24) gehalten ist,
eine Stirnfläche des Elektrodenabschnittes (24) gleich oder breiter einer Stirnfläche des dielektrischen Fensters (22) ausgebildet ist, so dass das dielektrische Fenster (22) verborgen ist,
**dadurch gekennzeichnet, dass** ein konkaver Abschnitt (26) in einer Oberfläche des Elektrodenabschnittes (24) ausgebildet ist, der dem Zentrum der Vakuumkammer (1) zugewandt, und
der Durchmesser des konkaven Abschnittes (26) an der Oberfläche, die dem Zentrum der Vakuumkammer zugewandt ist, in dem Bereich von 1/3 bis 5/3 der Wellenlänge der Mikrowellen liegt, die eingeleitet werden, und die Tiefe des konkaven Abschnittes von der Oberfläche, die dem Zentrum der Vakuumkammer zugewandt ist, zu dem tiefsten Abschnitt des konkaven Abschnittes in dem Bereich von 1/20 bis 3/5 der Wellenllänge der Mikrowellen liegt, die eingeleitet werden.

2. Mikrowellenplasma CVD-Vorrichtung nach Anspruch 1, bei der die Oberfläche des konkaven Abschnittes ellipsenförmig ist.

3. Mikrowellenplasma CVD-Vorrichtung nach Anspruch 1, bei der die Oberfläche des konkaven Abschnittes sphärisch ist.

## Revendications

1. Dispositif de CVD (dépôt chimique en phase vapeur) de plasma par micro-ondes comprenant au moines :
une chambre à vide (1) ayant une partie ouverte (2) pour l'introduction des micro-ondes ;
un guide d'onde (21) pour guider les micro-ondes vers la partie ouverte ;
une fenêtre diélectrique (22) pour introduire les microondes à l'intérieur de la chambre à vide (1) ;
une partie d'antenne (25) où une partie d'électrode (24) est formée sur une extrémité distale pour introduire les micro-ondes à l'intérieur de la chambre à vide (1) ; et
une table de support de matériau de base (11) pour supporter un matériau de base à l'intérieur de la chambre à vide (1),
avec la fenêtre diélectrique (22) qui est maintenue entre une surface interne de la chambre à vide (1) et la partie d'électrode (24),
une surface d'extrémité de la partie d'électrode (24) étant égale ou plus large qu'une surface d'extrémité de la fenêtre diélectrique (22) de sorte que la fenêtre diélectrique (22) est dissimulée,
**caractérisé en ce qu'**une partie concave (26) est formée dans une surface de la partie d'électrode (24) qui fait face au centre de la chambre à vide (1), et
le diamètre de la partie concave (26) au niveau de la surface qui fait face au centre de la chambre à vide représente de 1/3 à 5/3 de la longueur d'onde des micro-ondes qui sont introduites et la profondeur de la partie concave à partir de la surface qui fait face au centre de la chambre à vide jusqu'à la partie la plus profonde de la partie concave représente de 1/20 à 3/5 de la longueur d'onde des micro-ondes qui sont introduites.

2. Dispositif de CVD (dépôt chimique en phase vapeur) de plasma par micro-ondes selon la revendication 1, dans lequel la surface de la partie concave est sphéroïdale.

3. Dispositif de CVD (dépôt chimique en phase vapeur) de plasma par micro-ondes selon la revendication 1, dans lequel la surface de la partie concave est sphérique.
